# EUROPÄISCHE PATENTSCHRIFT

(11) **EP 0 457 934 B1**
(45) Veröffentlichungstag und Bekanntmachung des Hinweises auf die Patenterteilung: **13.09.1995**
(21) Anmeldenummer: 90109586.9
(22) Anmeldetag: 21.05.1990
(51) Int. Cl.: H03J 5/24

(54) **Schaltungsanordnung zur Bereichsumschaltung in Tunern**
Circuit arrangement for band switching in tuners
Arrangement de circuit pour la commutation de bande dans un tuner

(43) Veröffentlichungstag der Anmeldung: 27.11.1991
(73) Patentinhaber: SIEMENS AKTIENGESELLSCHAFT, 80333 München (DE)
(72) Erfinder: Hohmann, Henning, D-8000 München (DE)

(56) Entgegenhaltungen:
- EP-A- 0 299 578
- US-A- 4 442 548
- "ICs für die Unterhaltungselektronik" 1986, Siemens, DE

## Beschreibung

Die Erfindung betrifft eine Schaltungsanordnung zur Bereichsumschaltung in Tunern mit den Merkmalen des Oberbegriffs des Anspruches 1.

In Fernsehtunern sind üblicherweise zwei oder drei elektrisch weitgehend unabhängig voneinander betriebene Teiltuner enthalten, die die Fernsehfrequenzbereiche in den VHF-Bändern und im UHF-Band abdecken.

Herkömmliche Tuner benutzen für die zwei oder drei VHF-Bereiche gemeinsame Schwingkreise, deren Teilinduktivitäten für die Bereichsumschaltung mittels gleichspannungsgesteuerter Schalterdioden umgeschaltet werden.

Die Umschaltung zwischen dem VHF-und dem UHF-Bereich wird mittels pnp-Schaltertransistoren durchgeführt, die mit ihren Emittern an die Versorgungsspannungsklemme geschaltet sind und an deren Kollektoren die Teiltuner liegen. Die Basisanschlüsse sind mit Schaltausgängen einer integrierten Schaltung, im allgemeinen einer PLL-Schaltung verbunden. Diese Schaltausgänge sind strombegrenzte Open-Kollektor-Ausgänge, die bei der Auswahl eines Bereichs durch die Bedienelemente des Fernsehgerätes niederohmig werden und über den entsprechenden Schaltertransistor den Teiltuner mit Spannung versorgen. Eine interne Strombegrenzung in der integrierten Schaltung verhindert dabei einen zu hohen Basisstrom des Schaltertransistors. Die Umschaltung der VHF-Bereiche erfolgt dadurch, daß der von der integrierten Schaltung angesteuerte Schaltertransistor die zur Aktivierung der Schalterdioden notwendigen Ströme aufbringt.

Hyperbandtuner, also Tuner die auch das in Kabelnetzen verteilte Hyperband mit dem Frequenzbereich 300 bis 470 MHz abdecken, bestehen in der Regel aus drei elektrisch unabhängigen Teiltunern. Die Band- oder Bereichsumschaltung der abgestimmten Schwingkreise wird wegen der großen abzustimmenden Frequenzbereiche in der Regel nicht mit Schalterdioden durchgeführt. Dagegen werden direkt am Antenneneingang Schalterdioden eingesetzt, die nur den gerade ausgewählten Bereich an den Antennenanschluß des Fernsehgerätes schalten. Die Umschaltung der Teiltuner und der Schalterdioden erfolgt - wie oben beschrieben - mittels Schaltertransistoren.

In vielen Tunern wird heute eine integrierte Schaltung eingesetzt, die für den VHF- und den UHF-Bereich je einen Mischer und einen Oszillator enthält. In diese integrierte Schaltung ist auch eine Schalteinrichtung integriert, die durch Anlegen eines bestimmten Steuersignales, beispielsweise Spannungspegels, den gewünschten Mischer und Oszillator einschaltet. Das Steuersignal kann beispielsweise über entsprechend ausgelegte Spannungsteiler aus umgeschalteten Betriebsspannungen für die Teiltuner abgeleitet werden. Die Schaltertransistoren schalten in diesem Fall nur noch den Strom der Schalterdioden und die Betriebsspannung der Vorstufen des Tuners, in die üblicherweise MOS-Tetroden zur Verstärkung der Hochfrequenz eingesetzt werden. Zwei Schaltungsanordnungen zur Bereichsumschaltungen in Fernsehtunern mit MOS-Tetroden und einer integrierten Schaltung zur VHF/UHF-Umschaltung sind beispielsweise auf den Seiten 767 und 768 des Siemens Datenbuches 1986/87 "ICs für die Unterhaltungselektronik" beschrieben.

Darüber hinaus ist ein Tuner unter der Bezeichnung UV 816 von Philips bekannt vgl. auch EP-A-0 299 578, der keine Schaltertransistoren benötigt. Dies wird durch eine integrierte Schalteinrichtung mit nicht strombegrenzten Schaltausgängen erreicht, über die die ersten Gateanschlüsse der nicht einzuschaltenden MOS-Tetroden auf Bezugspotential gelegt werden. Damit werden diese MOS-Tetroden stromlos und verlieren ihre Verstärkung. Nur die MOS-Tetrode des aktiven Bereichs bleibt eingeschaltet, indem der dafür vorgesehene Schaltausgang der integrierten Schalteinrichtung hochohmig und damit inaktiv bleibt. Nachteilig bei diesem Prinzip ist:

Ein solcher Tuner benötigt zu seiner Steuerung eine Steuereinrichtung, also z. B. einen Mikroprozessor des Fernsehgerätes, mit einer anderen Software als bei den bisher benutzten oben beschriebenen Tunern, da einerseits andere Schaltausgänge der integrierten Schalteinrichtung notwendig und andererseits eine in ihrer Polarität entgegengesetzte Schaltlogik eingesetzt werden muß. Damit ist ein solcher Tuner zu den bisher bekannten Tunern nicht kompatibel.

Die von diesen Tunern benutzten Schaltausgänge der integrierten Schaltung können nicht zusätzlich - entgegen dem heute üblichen Standard - für Schaltaufgaben außerhalb des Tuners genutzt werden.

Darüber hinaus ist diese bekannte Schaltungsanordnung ohne zusätzlichen Aufwand nur für solche Tuner anwendbar, die drei Teiltuner und auch drei Vorstufen enthalten.

Der Erfindung liegt deshalb die Aufgabe zugrunde, eine Schaltungsanordnung zur Bereichsumschaltung in Tunern mit zwei Vorstufen anzugeben, die mit den bisherigen Tunern funktions- und softwarekompatibel ist und deren Schaltungsaufwand und Platzbedarf gegenüber den bisher bekannten Schaltungen reduziert ist.

Diese Aufgabe wird durch eine Schaltungsanordnung gemäß den Merkmalen des Patentanspruchs 1 gelöst. Weiterbildungen der Erfindung sind in den Unteransprüchen angegeben.

Die Erfindung wird im folgenden anhand von drei Figuren beispielhaft für die Bereichsumschaltung vom VHF-Bereich zum UHF-Bereich näher erläutert. Es zeigen:
- FIG 1: eine bekannte Schaltungsanordnung zur Bereichsumschaltung in Tunern mit zwei Bereichen,
- FIG 2: ein Beispiel für eine erfindungsgemäße Schaltungsanordnung zur Bereichsumschaltung in Tunern mit zwei Bereichen, wobei die Vorstufen der Bereiche nach Art einer ODER-Funktion ihrer Schaltzustände verkoppelt sind und über einen Schaltausgang einer Schalteinrichtung aktivierbar sind, und
- FIG 3: eine Weiterbildung der Schaltungsanordnung nach FIG 2 zur Umschaltung eines HF-Schwingkreises von einem niederfrequenten Bereich auf einen höherfrequenten Bereich unter Verwendung eines weiteren Schaltungsausganges der Schalteinrichtung.

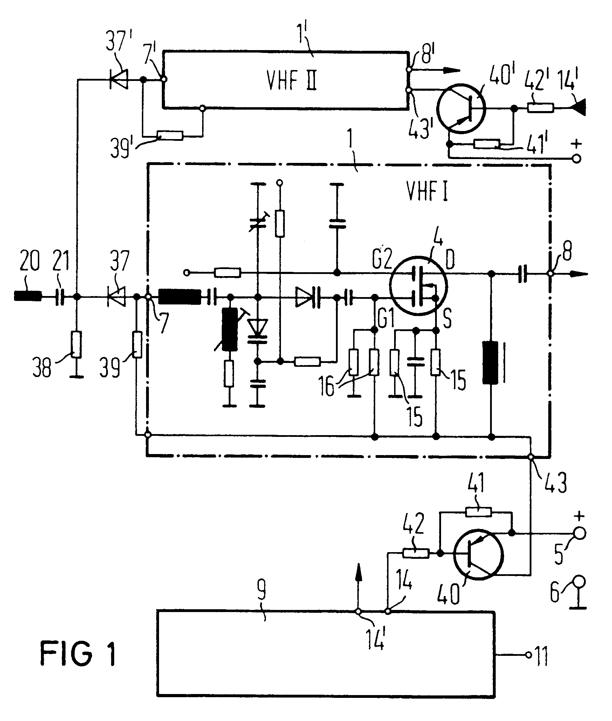

In FIG 1 ist die Eingangsstufe eines bekannten Fernsehtuners dargestellt. Die Eingangsstufe weist zwei Vorstufen 1, 1′ mit MOS-Tetroden 4 zur Verstärkung eines an eine Klemme 20 anzulegenden Antennensignals auf. Jeden der Vorstufen 1, 1′ ist für einen vorgegebenen Frequenzbereich dimensioniert. Über einen Koppelkondensator 21 gelangt dieses Antennensignal an die Kathoden von zwei Schalterdioden 37, 37′, deren Anoden mit jeweils einer Eingangsklemme 7, 7′ der Vorstufen 1, 1′ verbunden sind. An Ausgangsklemmen 8, 8′ ist ein für jeden Bereich von der jeweiligen Vorstufe 1, 1′ hochfrequenzverstärktes Signal abgreifbar. Der besseren Übersichtlichkeit wegen ist nur die Vorstufe 1 für einen ersten Bereich, hier z. B. den VHF-Bereich, mit seinen einzelnen Schaltungskomponenten detailliert dargestellt, wie diese an sich auch aus dem eingangs erwähnten Siemens Datenbuch 1986/87 bekannt sind. Im folgenden wird deshalb auf die Schaltungsanordnung nur insoweit eingegangen, als es für das Verständnis der Erfindung notwendig ist.

Der Sourceanschluß S der MOS-Tetrode 4 ist mit dem Verbindungspunkt eines ersten Spannungsteilers 15 und der erste Gateanschluß G1 mit dem Verbindungspunkt eines zweiten Spannungsteilers 16 zur Arbeitspunkteinstellung verbunden. Beide Spannungsteiler 15 und 16 liegen zwischen einer Bezugspotentialklemme 6 und einer Klemme 43, die über einen pnp-Schalttransistor 40 an eine Versorgungspotentialklemme 5 mit angelegter positiver Spannung schaltbar ist. Dazu ist der Kollektoranschluß dieses pnp-Schalttranistors 40 mit der Klemme 43 und dessen Basisanschluß über einen Basiswiderstand 42 an einen Schaltausgang 14 einer Schalteinrichtung 9 gelegt. Der Emitteranschluß des pnp-Schalttransistors 40 ist einerseits über einen Emitterwiderstand 41 mit dem Basisanschluß des pnp-Schalttransistors 40 und andererseits direkt mit der Versorgungspotentialklemme 5 in Verbindung. Gesteuert wird der Schaltausgang 14 der Schalteinrichtung 9 über einen oder mehrere Steueranschlüsse 11 mittels eines oder mehrerer Steuersignale. Zusätzlich ist die Anode der Schalterdiode 37 über einen Widerstand 39 an die Klemme 43 der Vorstufe 1 angeschlossen.

Wird nach Maßgabe des oder der an den oder die Steueranschlüsse 11 angelegten Steuersignales bzw. Steuersignale der Schaltausgang 14 der Schalteinrichtung 9 bei der Auswahl des VHF-Bereiches durch Bedienelemente im Fernsehgerät niederohmig, also auf Bezugspotential geschaltet, so schaltet der pnp-Schalttransistor 40 ein. Die positive Spannung an der Versorgungspotentialklemme 5 gelangt damit an die Klemme 43, wodurch die Vorstufe 1 an die positive Spannung gelegt und damit aktiviert wird. Zugleich wird die Schalterdiode 37 leitend, da jetzt deren Kathode negativer als deren Anode ist. Den Strom zum Schalten dieser Schalterdiode 37 liefert der pnp-Schalttransistor 40. Das an der Klemme 20 anliegende und zu verstärkende Antennensignal wird somit in der Vorstufe 1 verstärkt und steht an der Ausgangsklemme 8 zur Verfügung.

Das Umschalten auf den anderen Bereich, hier also die Vorstufe 1′ für den UHF-Bereich, erfolgt in analoger Weise über den Schaltausgang 14′ der Schalteinrichtung 9 sowie zusätzlich noch durch die mit den Bezugszeichen 7′, 37′, 40′, 41′, 42′ und 43′ bezeichneten Schaltungskomponenten. Gleiche Ziffern der Bezugszeichen bezeichnen dabei analoge Schaltelemente. Bei niederohmigem Schaltausgang 14′ wird die Vorstufe 1′ über den dann eingeschalteten pnp-Schalttransistor 40′ an die Versorgungspotentialklemme 5 geschaltet und damit als Verstärker aktiv.

Die Schaltausgänge 14, 14′ der Schalteinrichtung 9 sind strombegrenzte Open-Kollektor-Ausgänge. Eine Strombegrenzung in der Schalteinrichtung 9 verhindert einen zu hohen Basisstrom der pnp-Schalttransistoren 40, 40′.

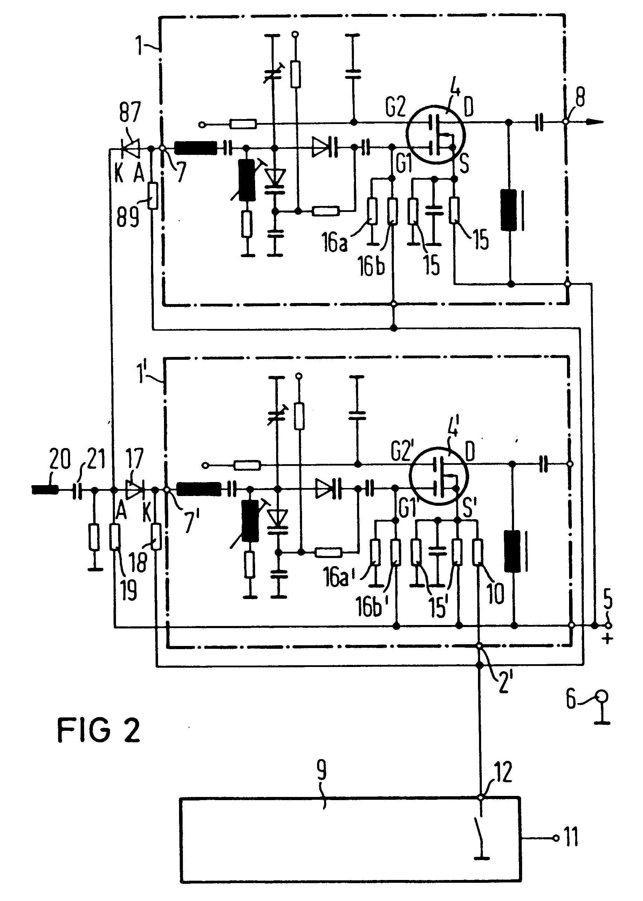

FIG 2 zeigt ein Ausführungsbeispiel einer erfindungsgemäßen Schaltungsanordnung zur Bereichsumschaltung in Tunern mit zwei Bereichen. Gleiche Teile sind wieder mit gleichen Bezugszeichen wie in FIG 1 versehen. Für jeden der Bereiche ist eine eigene Vorstufe 1, 1′ mit je einer MOS-Tetrode 4, 4′ als zur Hochfrequenzverstärkung dienendes Bauelement vorgesehen. Die Vorstufen 1, 1′ sind im wesentlichen wie in FIG 1 aufgebaut.

Die beiden Vorstufen 1, 1′ sind jedoch jetzt nach Art einer Oder-Funktion ihrer Schaltzustände miteinander verkoppelt. Dazu ist in der ersten Vorstufe 1 der erste aus den Widerständen 16a und 16b bestehende Spannungsteiler mit seinem Verbindungspunkt an den ersten Gateanschluß G1 der MOS-Tetrode 4 geschaltet. Der Widerstand 16a liegt auf Bezugspotential, während der zweite Widerstand 16b mit einer Schaltausgangsklemme 12 einer Schalteinrichtung 9 verbunden ist. Der mit seinem Verbindungspunkt an den Sourceanschluß S geschaltete Spannungsteiler 15 liegt - wie in FIG 1 auch - zwischen der Versorgungspotentialklemme 5 und der Bezugspotentialklemme 6.

Die zweite Vorstufe 1′ entspricht wieder der Schaltung einer Vorstufe von FIG 1, wobei der erste zwischen die Versorgungspotentialklemme 5 und Bezugspotentialklemme 6 geschaltete Spannungsteiler 15′ mit seinen Verbindungspunkt an den Sourceanschluß S′ und der zweite zwischen die Versorgungspotentialklemme 5 und Bezugspotentialklemme 6 geschaltete Spannungsteiler 16a′, 16b′ mit seinem Verbindungspunkt an den ersten Gateanschluß G1′ der MOS-Tetrode geschaltet ist. Zusätzlich ist bei dieser Vorstufe 1′ die MOS-Tetrode 4′ mit ihrem Sourceanschluß S′ über einen Widerstand 10 an den Schaltausgang 12 der Schalteinrichtung 9 geschaltet. Dieser Widerstand 10, der zu einem Widerstand des ersten Spannungsteilers 15′ parallel geschaltet ist, ist vorteilhafterweise so bemessen, daß sich der für optimale Verstärkung vorgesehene Arbeitspunkt der MOS-Tetrode 4′ einstellt.

Darüber hinaus ist bei der zweiten Vorstufe 1′ der erste Spannungsteiler 15′ und zweite Spannungsteiler 16a′, 16b′ so eingestellt, daß am Sourceanschluß S′ eine negative Spannung gegenüber dem ersten Gatenanschluß G1 erreicht wird, die einerseits groß genug ist, einen in der MOSTetrode 4′ sich ausbildenden Kanal abzuschnüren und andererseits unterhalb der Ansprechschwelle von an den ersten Gateanschluß G1′ und zweiten Gateanschluß G2′ der MOS-Tetrode 4′ geschaltete Schutzdioden bleibt.

Durch eine solche erfindungsgemäße Schaltungsanordnung, wie sie in FIG 2 dargestellt ist, wird gewährleistet, daß bei inaktivem Schaltausgang 12 der Schalteinrichtung 9, d. h. daß der Schaltausgang 12 hochohmig ist, die MOS-Tetrode 4′ der zweiten Vorstufe 1′ über den ersten Spannungsteiler 15′ am Sourceanschluß S′ und über den zweiten Spannungsteiler 16a′, 16b′ am ersten Gateanschluß G1′ so vorgespannt ist, daß der Kanal der MOS-Tetrode 4 abgeschnürt und damit diese stromlos und ausgeschaltet ist. Die MOS-Tetrode 4 der ersten Vorstufe 1 erhält dagegen über den Spannungsteiler 16a, 16b ein solches Potential an seinem ersten Gateanschluß G1 und über den Spannungsteiler 15 ein solches Potential an seinem Sourceanschluß S, daß sich der Strom in dieser Vorstufe 1 für volle Verstärkung einstellt.

Wird dagegen der Schaltausgang 12 der Schalteinrichtung 9 durch an eine Signaleingangsklemme 11 angelegte Steuersignale niederohmig, so wird der Widerstand 10 der zweiten Vorstufe 1′ an die Bezugspotentialklemme 6 gelegt. Dadurch stellt sich der Arbeitspunkt der MOS-Tetrode 4′ so ein, daß eine volle Verstärkung in der zweiten Vorstufe 1′ erreicht wird. Gleichzeitig wird über den aus den Widerständen 16a und 16 bestehenden Spannungsteiler der ersten Vorstufe 1 das Potential am ersten Gateanschluß G1 der MOS-Tetrode 4 an die Bezugspotentialklemme 6 geschaltet. Wegen der weiterhin bestehen Vorspannung an dessen Sourceanschluß S ist damit die MOS-Tetrode 4 gesperrt. Die Umschaltung der beiden MOS-Tetroden 4, 4′ kann damit also mit nur einem einzigen Schaltausgang 12 der Schalteinrichtung 9 und ohne zusätzliche externe Schaltertransistoren vorgenommen werden.

Von Vorteil aber nicht zwingend ist, daß zusätzlich je eine Schalterdiode 87 und 17 an die Eingangsklemmen 7 und 7′ der Vorstufe 1 und 1′ geschaltet ist. Die Schalterdiode 17 ist mit ihrer Kathode an die Eingangsklemme 7′ der zweiten Vorstufe 1′ geschaltet und über einen im Vergleich zur Eingangsimpedanz der Vorstufe 1′ hochohmigen Widerstand 18 mit dem Schaltausgang 12 der Schalteinrichtung 9 verbunden, wobei ein dritter zwischen die Versorgungspotentialklemme 5 und Bezugspotentialklemme 6 geschalteter Spannungsteiler 19 vorgesehen ist, der mit seinem Verbindungspunkt an die Anode dieser Schalterdiode 17 geschaltet ist.

Die Schalterdiode 87 ist dagegen mit ihrer Anode an die Eingangsklemme 7 der Vorstufe 1 geschaltet und mit ihrer Kathode an die Anode der Schalterdiode 17. Zusätzlich ist an die Anode der Schalterdiode 87 ein Widerstand 89 geschaltet, der mit seinem anderen Anschluß auch an den Schaltausgang 12 der Schalteinrichtung 9 gelegt ist. Dieser Widerstand 89 ist hochohmig im Vergleich zur Eingangsimpedanz der Vorstufe 1 gewählt.

Durch diese Maßnahme wird bewirkt, daß - solange der Schaltausgang 12 nicht auf Bezugspotential geschaltet ist - die Schalterdiode 17 sperrt und damit an die Eingangsklemme 7′ der Vorstufe 1′ kein Antennensignal gelangen kann. Die Schalterdiode 17 sperrt die Vorstufe 1′, da deren Anode durch den dritten Spannungsteiler 19 negativer als deren Kathode ist. Die Schalterdiode 87 leitet dagegen.

Soll dagegen die Vorstufe 1′ aktiviert und folglich die Vorstufe 1 ausgeschaltet werden, so muß die MOS-Tetrode 4′ der Vorstufe 1′ einschalten, indem der Schaltausgang 12 der Schalteinrichtung 9 auf Bezugspotential gelegt wird. Die Schalterdiode 17 führt dann Strom, weil deren Anodenpotential positiver als deren Kathodenpotential wird. Die Schalterdiode 87 sperrt dagegen.

Der Verbindungspunkt der beiden Schalterdioden 17 und 87 ist über ein Koppelglied 21 z. B. den aus FIG 1 bekannten Koppelkondensator, an die Klemme 20 für das hochfrequente Eingangssignal angeschlossen.

Als Schalteinrichtung 9 eignet sich besonders eine integrierte Schaltung, deren für die Bereichsumschaltung notwendiger Schaltausgang 12 keine Strombegrenzung aufweisen muß. Besonders vorteilhaft ist, daß die Ansteuerung des Schaltausgangs 12 kompatibel zur Steuersoftware der bisherigen Tuner ausgebildet sein kann. Die Schalteinrichtung 9 kann darüber hinaus beispielsweise in einer integrierten PPL(phase-locked-loop)-Schaltung enthalten sein, die die zur Frequenzeinstellung und Bandumschaltung notwendigen Stufen aufweist.

Es hat sich herausgestellt, daß in der Schalteinrichtung 9 der Schalttransistor zum Ansteuern des Schaltausgangs 12 so bemessen sein soll, daß dieser bei einer Spannungsfestigkeit von etwa 12 V einen Strom von etwa 25 mA schalten kann.

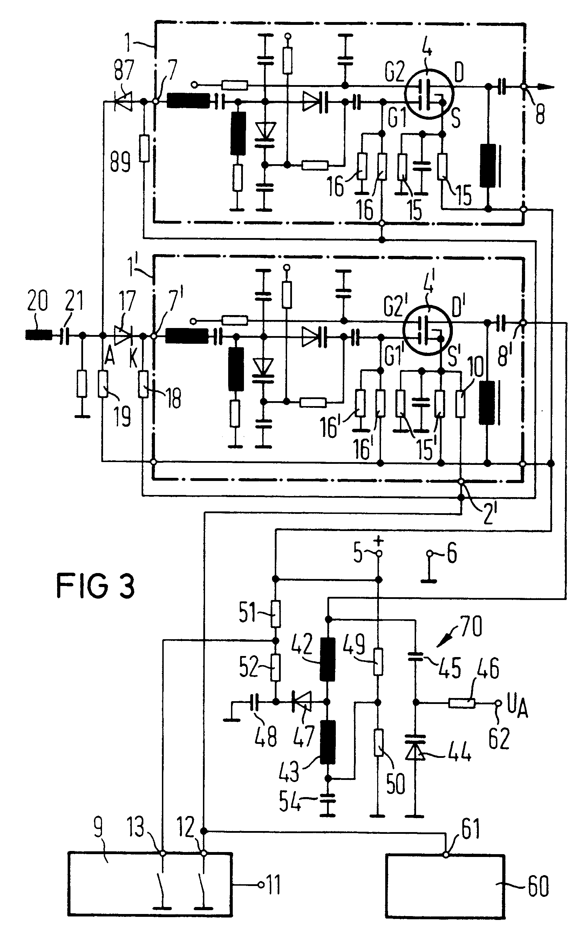

Eine Weiterbildung der erfindungsgemäßen Schaltungsanordnung ist in FIG 3 dargestellt. Zusätzlich zum Schaltausgang 12, der zum Umschalten zwischen den beiden Vorstufen 1 und 1′ vorgesehen ist, weist die Schalteinrichtung 9 jetzt einen weiteren Schaltausgang 13 auf, um einen HF-Schwingkreis 70, beispielsweise einen VHF-Schwingkreis, der an die Ausgangsklemme 8′ der zweiten Vorstufe 1′ geschaltet ist, von einem niederfrequenten Bereich auf einen höherfrequenten Bereich und umgekehrt umzuschalten.

Dazu verfügt dieser HF-Schwingkreis über folgende Merkmale:
- eine mit ihrer Anode an die Bezugspotentialklemme 6 angeschlossene Kapazitätsdiode 44,
- deren Kathode mit der Reihenschaltung eines ersten Kondensators 45 und einer ersten Spule 42 und einer zweiten Spule 43 sowie einem zweiten an die Bezugspotentialklemme 6 angeschlossenen Kondensator 54 verbunden ist,
- einen zwischen eine Klemme 62 und der Kathode der Kapazitätsdiode 44 geschalteter Widerstand 46 zur Zuführung einer Abstimmspannung U_{A},
- einen vierten zwischen die Bezugspotentialklemme 6 und die Versorgungspotentialklemme 5 geschalteten Spannungsteiler 49, 50 deren Verbindungspunkt mit dem Verbindungspunkt des zweiten Kondensators 54 und der zweiten Spule 43 verbunden ist,
- eine weitere Schaltdiode 47, die mit ihrer Anode an den Verbindungspunkt der ersten Spule 42 und zweiten Spule 43 geschaltet ist und deren Kathode einerseits mit einem an die Bezugspotentialklemme 6 angeschlossenen Kondensator 48 und andererseits mit einem an die Versorgungspotentialklemme 5 angeschlossenen fünften Spannungsteiler 51, 52 verbunden ist,
- deren Verbindungspunkt an eine weitere Signalausgangsklemme 13 der Schalteinrichtung 9 angeschlossen ist.

Die Ausgangsklemme 8′ der zweiten Vorstufe ist in diesem Ausführungsbeispiel mit dem Verbindungspunkt der Spule 42 und dem Kondensator 45 in Verbindung.

Das Umschalten zwischen dem niederfrequenten Bereich und dem höherfrequenten Bereich dieses HF-Schwingkreises 70 funktioniert folgendermaßen: Im inaktiven Zustand des Schaltausgangs 13, d. h. daß der Schaltausgang 13 hochohmig ist, ist die Schalterdiode 47 dadurch gesperrt, daß über den hochohmigen Widerstand 51 die Kathode der Schalterdiode 47 auf einem höheren Potential liegt als deren Anode. Dies wird durch den aus den Widerständen 49 und 50 bestehenden Spannungsteiler erreicht. Da die Spulen 42 und 43 somit in Reihe geschaltet sind, ist der niederfrequente Bereich des HF-Schwingkreises 70 wirksam.

Im aktiven Zustand des Schaltausgangs 13, d. h. daß der Schaltausgang 13 mit der Bezugspotentialklemme 6 in Verbindung ist, fließt durch die Schalterdiode 47 ein Strom, der diese niederohmig macht. Damit ist die Spule 13 kurzgeschlossen und der HF-Schwingkreis 70 auf seinen hochfrequenten Bereich geschaltet.

Mit einer solchen Schaltungsanordnung kann das Umschalten der beiden Bereiche des HF-Schwingkreises 70 mit nur einem einzigen Schaltausgang 13 der Schalteinrichtung 9 ohne extern notwendigen Schaltertransistor durchgeführt werden.

Darüber hinaus ist es möglich, einen Bandumschalteingang 61 einer Mischerstufe und/oder Oszillatorschaltung 60 mit den Schaltausgängen 12 oder 13 der Schalteinrichtung 9 zu verbinden, um diese anzusteuern.

## Patentansprüche

1. Schaltungsanordnung zur Bereichsumschaltung in Tunern mit zwei Bereichen, für die jeweils eine eine MOS-Tetrode (4, 4′) aufweisende und zwischen jeweils eine Versorgungspotentialklemme (5) und eine Bezugspotentialklemme (6) geschaltete Vorstufe (1, 1′) mit einer Eingangsklemme (7, 7′) und einer Ausgangsklemme (8, 8′) vorgesehen sind, wobei jede der MOS-Tetroden (4, 4′) über eine Schalteinrichtung (9) aktivierbar ist,
**dadurch gekennzeichnet**,
daß die beiden Vorstufen (1, 1′) an eine mit der Bezugspotentialklemme (6) verbindbare Schaltausgangsklemme (12) der Schalteinrichtung (9) geschaltet sind und daß die beiden Vorstufen (1, 1′) so miteinander verkoppelt sind, daß - abhängig vom Schaltzustand der Schaltausgangsklemme (12) - nur jeweils eine der Vorstufen (1, 1′) aktivierbar ist.

2. Schaltungsanordnung nach Anspruch 1,
**dadurch gekennzeichnet**,
daß die MOS-Tetrode (4) einer Vorstufe (1) mit ihrem ersten Gateanschluß (G1) über einen ersten Widerstand (16b) an die Signalausgangsklemme (12) der Schalteinrichtung (9) geschaltet ist, und daß die MOS-Tetrode (4′) der anderen Vorstufe (1′) mit ihrem Sourceanschluß (S′) über einen zweiten Widerstand (10) an diese Signalausgangsklemme (12) geschaltet ist.

3. Schaltungsanordnung nach Anspruch 1 oder 2,
**dadurch gekennzeichnet**,
daß in der einen Vorstufe (1) ein erster zwischen die Versorgungspotentialklemme (5) und Bezugspotentialklemme (6) geschalteter Spannungsteiler (15) mit seinem Verbindungspunkt an den Sourceanschluß (S) und ein zweiter den ersten Widerstand (16b) enthaltener und zwischen die Signalausgangsklemme (12) und Bezugspotentialklemme (6) geschalteter Spannungsteiler (16a,16b) mit seinem Verbindungspunkt an den ersten Gateanschluß (G1) der MOS-Tetrode (4) geschaltet ist.

4. Schaltungsanordnung nach Anspruch 3,
**dadurch gekennzeichnet**,
daß in der anderen Vorstufe (1′) ein erster zwischen die Versorgungspotentialklemme (5) und Bezugspotentialklemme (6) geschalteter Spannungsteiler (15′) mit seinem Verbindungspunkt an den Sourceanschluß (S′) und ein zweiter zwischen die Versorgungspotentialklemme (5) und Bezugspotentialklemme (6) geschalteter Spannungsteiler (16a′,16b′) mit seinem Verbindungspunkt an einen ersten Gateanschluß (G1′) der MOS-Tetrode (4′) geschaltet ist.

5. Schaltungsanordnung nach Anspruch 4,
**dadurch gekennzeichnet**,
daß in der anderen Vorstufe (1′) der erste Spannungsteiler (15′) und zweite Spannungsteiler (16a′,16b′) so eingestellt sind, daß am Sourceanschluß (S′) eine negative Spannung erreicht wird, die einerseits groß genug ist, einen in der MOS-Tetrode (4′) sich ausbildenden Kanal abzuschnüren und andererseits unterhalb der Ansprechschwelle von an den ersten Gateanschluß (G1′) und zweiten Gateanschluß (G2′) der MOS-Tetrode (4′) geschaltete Schutzdioden bleibt.

6. Schaltungsanordnung nach einem der Ansprüche 1 bis 5,
**dadurch gekennzeichnet**,
daß an die Eingangsklemme (7′) der anderen Vorstufe (1′) eine Schalterdiode (17) mit ihrer Kathode geschaltet ist, deren Anode über mindestens ein Koppelglied (21) an eine Klemme (20) für ein HF-Signal angeschlossen ist, wobei die Anode dieser Schalterdiode (17) über einen im Vergleich zur Eingangsimpedanz der anderen Vorstufe (1′) hochohmigen Widerstand (18) mit der Signalausgangsklemme (12) der Schalteinrichtung (9) verbunden ist und wobei ein dritter zwischen die Versorgungspotentialklemme (5) und Bezugspotentialklemme (6) geschalteter Spannungsteiler (19) vorgesehen ist, der mit seinem Verbindungspunkt an die Anode der Schalterdiode (17) geschaltet ist.

7. Schaltungsanordnung nach einem der Ansprüche 1 bis 6,
**dadurch gekennzeichnet**,
daß an die Eingangsklemme (7) der einen Vorstufe (1) eine Schalterdiode (87) mit ihrer Anode geschaltet ist, deren Kathode über mindestens das Koppelglied (21) an die Klemme (20) angeschlossen ist, wobei die Anode über einen im Vergleich zur Eingangsimpedanz der einen Vorstufe (1) hochohmigen Widerstand (89) mit der Signalausgangsklemme (12) der Schalteinrichtung (9) verbunden ist und wobei der dritte Spannungsteiler (19) mit seinem Verbindungspunkt an der Kathode der Schalterdiode (87) liegt.

8. Schaltungsanordnung nach einem der Ansprüche 1 bis 7,
**dadurch gekennzeichnet**,
daß die Schalteinrichtung (9) einen weiteren Schaltausgang (13) zum Umschalten eines HF-Schwingkreises (70) zwischen einem niederfrequenten Bereich und einem hochfrequenten Bereich aufweist.

9. Schaltungsanordnung nach Anspruch 8,
**dadurch gekennzeichnet**,
daß der HF-Schwingkreis (70) folgende Merkmale aufweist:
- eine mit ihrer Anode an die Bezugspotentialklemme (6) angeschlossene Kapazitätsdiode (44),
- deren Kathode mit der Reihenschaltung eines ersten Kondensators (45) und einer ersten Spule (42) und einer zweiten Spule (43) sowie einem zweiten an die Bezugspotentialklemme (6) angeschlossenen Kondensator (54) verbunden ist,
- einen zwischen eine Klemme (62) und der Kathode der Kapazitätsdiode (44) geschalteten Widerstand (46) zur Zuführung einer Abstimmspannung (U_{A}),
- einen vierten zwischen die Bezugspotentialklemme (6) und die Versorgungspotentialklemme (5) geschalteten Spannungsteiler (49, 50) deren Verbindungspunkt mit dem Verbindungspunkt des zweiten Kondensators (54) und der zweiten Spule (43) verbunden ist,
- eine weitere Schaltdiode (47), die mit ihrer Anode an den Verbindungspunkt der ersten Spule (42) und zweiten Spule (43) geschaltet ist und deren Kathode einerseits mit einem an die Bezugspotentialklemme (6) angeschlossenen Kondensator (48) und andererseits mit einem an die Versorgungspotentialklemme (5) angeschlossenen fünften Spannungsteiler (51, 52) verbunden ist,
- deren Verbindungspunkt an eine weitere Signalausgangsklemme (13) der Schalteinrichtung (9) angeschlossen ist.

10. Schaltungsanordnung nach einem der Ansprüche 1 bis 9,
**dadurch gekennzeichnet**,
daß eine der Schaltausgänge (12, 13) der Schalteinrichtung (9) zusätzlich zur Umschaltung einer Mischstufe und/oder Oszillatoreinrichtung (60) des Tuners vorgesehen ist.

11. Fernsehgerät mit einer Schaltungsanordnung nach einem der Ansprüche 1 bis 9.

12. Schaltungsanordnung nach Anspruch 8 oder 9,
**dadurch gekennzeichnet**,
daß der HF-Schwingkreis (70) ein VHF-Schwingkreis ist.

## Claims

1. Circuit arrangement for band switching in tuners having two bands for each of which an input stage (1, 1′) is provided which has an MOS tetrode (4, 4′), is connected between in each case one supply potential terminal (5) and a reference-earth potential terminal (6) and has an input terminal (7, 7′) and an output terminal (8, 8′), it being possible to activate each of the MOS tetrodes (4, 4′) via a switching device (9), characterized in that the two input stages (1, 1′) are connected to a switching output terminal (12), which can be connected to the reference-earth potential terminal (6), of the switching device (9), and in that the two input stages (1, 1′) are coupled to one another such that - depending on the switching state of the switching output terminal (12) - only one of the input stages (1, 1′) can in each case be activated.

2. Circuit arrangement according to Claim 1, characterized in that the MOS tetrode (4) of one input stage (1) is connected by means of its first gate connection (G1) via a first resistor (16b) to the signal output terminal (12) of the switching device (9), and in that the MOS tetrode (4′) of the other input stage (1′) is connected by means of its source connection (S′) via a second resistor (10) to this signal output terminal (12).

3. Circuit arrangement according to Claim 1 or 2, characterized in that, in the one input stage (1), a first voltage divider (15), which is connected between the supply potential terminal (5) and the reference-earth potential terminal (6), is connected by means of its junction point to the source connection (S), and a second voltage divider (16a, 16b), which includes the first resistor (16b) and is connected between the signal output terminal (12) and the reference-earth potential terminal (6), is connected by means of its junction point to the first gate connection (G1) of the MOS tetrode (4).

4. Circuit arrangement according to Claim 3, characterized in that, in the other input stage (1′), a first voltage divider (15′), which is connected between the supply potential terminal (5) and the reference-earth potential terminal (6), is connected by means of its junction point to the source connection (S′), and a second voltage divider (16a′, 16b′), which is connected between the supply potential terminal (5) and the reference-earth potential terminal (6), is connected by means of its junction point to a first gate connection (G1′) of the MOS tetrode (4′).

5. Circuit arrangement according to Claim 4, characterized in that, in the other input stage (1′), the first voltage divider (15′) and the second voltage divider (16a′, 16b′) are set such that a negative voltage is achieved at the source connection (S′), which negative voltage is on the one hand high enough to cut off a channel which is formed in the MOS tetrode (4′) and, on the other hand, remains below the response threshold of protection diodes which are connected to the first gate connection (G1′) and to the second gate connection (G2′) of the MOS tetrode (4′).

6. Circuit arrangement according to one of Claims 1 to 5, characterized in that the cathode of a switch diode (17) is connected to the input terminal (7′) of the other input stage (1′), its anode is connected via at least one coupling element (21) to a terminal (20) for an RF signal, the anode of this switch diode (17) being connected via a resistor (18), whose resistance is high in comparison with the input impedance of the other input stage (1′), to the signal output terminal (12) of the switching device (9), and a third voltage divider (19) being provided which is connected between the supply potential terminal (5) and the reference-earth potential terminal (6) and whose junction point is connected to the anode of the switch diode (17).

7. Circuit arrangement according to one of Claims 1 to 6, characterized in that the anode of a switch diode (87) is connected to the input terminal (7) of the one input stage (1) and its cathode is connected via at least the coupling element (21) to the terminal (20), the anode being connected via a resistor (89), whose resistance is high in comparison with the input impedance of the one input stage (1), to the signal output terminal (12) of the switching device (9), and the junction point of the third voltage divider (19) is connected to the cathode of the switch diode (87).

8. Circuit arrangement according to one of Claims 1 to 7, characterized in that the switching device (9) has a further switching output (13) for switching an RF tuned circuit (70) over between a band at a lower frequency and a band at a higher frequency.

9. Circuit arrangement according to Claim 8, characterized in that the RF tuned circuit (70) has the following features:
- a capacitance diode (44) whose anode is connected to the reference-earth potential terminal (6),
- whose cathode is connected to the series circuit formed by a first capacitor (45), a first coil (42) and a second coil (43), and to a second capacitor (54) which is connected to the reference-earth potential terminal (6),
- a resistor (46), which is connected between a terminal (62) and the cathode of the capacitance diode (44), for supplying a tuning voltage (U_{A}),
- a fourth voltage divider (49, 50), which is connected between the reference-earth potential terminal (6) and the supply potential terminal (5) and whose junction point is connected to the junction point of the second capacitor (54) and the second coil (43),
- a further switching diode (47) whose anode is connected to the junction point of the first coil (42) and the second coil (43), and whose cathode is connected on the one hand to a capacitor (48) which is connected to the reference-earth potential terminal (6), and on the other hand to a fifth voltage divider (51, 52) which is connected to the supply potential terminal (5) and
- whose junction point is connected to a further signal output terminal (13) of the switching device (9).

10. Circuit arrangement according to one of Claims 1 to 9, characterized in that one of the switching outputs (12, 13) of the switching device (9) is additionally provided for switching over a mixer stage and/or oscillator device (60) of the tuner.

11. Television set having a circuit arrangement according to one of Claims 1 to 9.

12. Circuit arrangement according to Claim 8 or 9, characterized in that the RF tuned circuit (70) is a VHF tuned circuit.

## Revendications

1. Montage de commutation de gammes dans des syntoniseurs comportant deux gammes, pour chacune desquelles il est prévu un étage amont (1,1′) comportant une tétrode MOS (4,4′) et branché entre respectivement une borne (5) du potentiel d'alimentation et une borne (6) du potentiel de référence et comportant une borne d'entrée (7,7′) et une borne de sortie (8,8′), chacune des tétrodes MOS (4,4′) pouvant être activée par l'intermédiaire d'un dispositif de commutation (9), caractérisé en ce que les deux étages amont (1,1′) sont raccordés à une borne de sortie de commutation (12) du dispositif de commutation (9), qui peut être reliée à la borne de potentiel de référence (6), et que les deux étages amont (1,1′) sont couplés entre eux de telle sorte que - en fonction de l'état de commutation de la borne de sortie de commutation (12) - seul l'un des étages amont (1,1′) peut être activé.

2. Montage suivant la revendication 1, caractérisé en ce que la tétrode MOS (4) d'un étage amont (1) est raccordée par sa première borne de grille (G1), et par l'intermédiaire d'une première résistance (16b), à la borne de sortie de signal (12) du dispositif de commutation (9), et que la tétrode MOS (4′) de l'étage amont (1) est raccordée par sa borne de source (S′), et par l'intermédiaire d'une seconde résistance (10), à cette borne de sortie de signal (12).

3. Montage suivant la revendication 1 ou 2, caractérisé en ce que dans un étage amont (1), le premier diviseur de tension (15) branché entre la borne de potentiel d'alimentation (5) et la borne de potentiel de référence (6) est raccordé, par son point de jonction, à la borne de source (S) de la tétrode MOS (4) et un second diviseur de tension (16a,16b), qui comporte la première résistance (16b) et est branché entre la borne de sortie de signal (12) et la borne de potentiel de référence (6) , est raccordé, par son point de jonction, à la première grille (G1) de la tétrode MOS (4).

4. Montage suivant la revendication 3, caractérisé par le fait que dans l'autre étage amont (1′), un premier diviseur de tension (15′) branché entre la borne de potentiel d'alimentation (5) et la borne de potentiel de référence (6), est raccordé, par son point de jonction, à la borne de source (S′) de la tétrode MOS 4′, et un second diviseur de tension (16a′,16b′) branché entre la borne de potentiel d'alimentation (5) et la borne de potentiel de référence (6), est raccordé, par son point de jonction, à la première borne de grille (G1′) de la tétrode MOS (4′).

5. Montage suivant la revendication 4, caractérisé par le fait que dans l'autre étage amont (1′), le premier diviseur de tension (15′) et le second diviseur de tension (16a′, 16b′) sont réglés de telle sorte que sur la borne de source (S′) est atteinte une tension négative qui, d'une part, est suffisamment élevée pour rétrécir un canal qui se forme dans la tétrode MOS (4′), et, d'autre part, reste inférieure au seuil de réponse de diodes de protection raccordées à la première borne de grille (G1′) et à la seconde borne de grille (G2′) de la tétrode MOS (4′).

6. Montage suivant l'une des revendications 1 à 5, caractérisé par le fait qu'à la borne d'entrée (7′) de l'autre étage amont (1′) est raccordée, par sa cathode, une diode de commutation (17), dont l'anode est raccordée, par l'intermédiaire d'au moins un circuit de couplage (21), à une borne (20) pour un signal HF, l'anode de cette diode de commutation (17) étant reliée, par l'intermédiaire d'une résistance (18) qui possède une forte valeur ohmique par rapport à l'impédance d'entrée de l'autre étage amont (1′), à la borne de sortie de signal (12) du dispositif de commutation (9), et qu'il est prévu un troisième diviseur de tension (19), qui est branché entre la borne de potentiel d'alimentation (5) et la borne de potentiel de référence (6) et est raccordé, par son point de jonction, à l'anode de la diode de commutation (17).

7. Montage suivant l'une des revendications 1 à 6, caractérisé par le fait qu'à la borne d'entrée (7) d'un étage amont (1) est raccordé, par son anode, une diode de commutation (87), dont la cathode est raccordée, par l'intermédiaire au moins du circuit de couplage (21), à la borne (20), l'anode étant reliée, par l'intermédiaire d'une résistance (89) possédant une forte valeur ohmique par rapport à l'impédance d'entrée de l'étage amont (1), à la borne de sortie de signal (12) du dispositif de commutation (9), et le troisième diviseur de tension (19) étant relié, par son point de jonction, à la cathode de la diode de commutation (87).

8. Montage suivant l'une des revendications 1 à 7, caractérisé par le fait que le dispositif de commutation (9) possède une autre sortie de commutation (13) pour la commutation d'un circuit oscillant HF (70) entre une gamme de basses fréquences et une gamme de hautes fréquences.

9. Montage suivant la revendication 8, caractérisé par le fait que le circuit oscillant HF (70) possède les caractéristiques suivantes :
- une diode capacitive (44) raccordée par son anode à la borne de potentiel de référence (6),
- dont la cathode est reliée au circuit série formé d'un premier condensateur (45) et d'une première bobine (42) et d'une seconde bobine (43) ainsi que d'un second condensateur (54) raccordé à la borne de potentiel de référence (6),
- une résistance (46) branchée entre une borne (62) et la cathode de la diode capacitive (44), pour l'envoi d'une tension de réglage d'accord (U_{A}),
- un quatrième diviseur de tension (40,50), qui est branché entre la borne de potentiel de référence (6) et la borne de potentiel d'alimentation (5) et dont le point de jonction est relié au point de jonction du second condensateur (54) et de la seconde bobine (43),
- une autre diode de commutation (47), qui est raccordée, par son anode, au point de jonction de la première bobine (42) et de la seconde bobine (43) et dont la cathode est reliée, d'une part, à un condensateur (48) raccordé à la borne de potentiel de référence (6), et, d'autre part, à un cinquième diviseur de tension (51,52) raccordé à la borne de potentiel d'alimentation (5), et
- dont le point de jonction est raccordé à une autre borne de sortie de signal (13) du dispositif de commutation (9).

10. Montage suivant l'une des revendications 1 à 9, caractérisé par le fait que l'une des sorties de commutation (12,13) du dispositif de commutation (9) est prévue en supplément pour la commutation d'un étage mélangeur et/ou du dispositif oscillateur (60) du syntoniseur.

11. Appareil de télévision comportant un montage suivant l'une des revendications 1 à 9.

12. Montage suivant la revendication 8 ou 9, caractérisé par le fait que le circuit oscillant HF (70) est un circuit oscillant VHF.
